# EUROPEAN PATENT SPECIFICATION

(11) **EP 0 764 362 B1**
(45) Date of publication and mention of the grant of the patent: **16.08.2001**
(21) Application number: 95922515.2
(22) Date of filing: 06.06.1995
(51) Int. Cl.: H03F 1/02

(54) **LINEAR MICROWAVE POWER AMPLIFIER WITH SUPPLY POWER INJECTION CONTROLLED BY THE MODULATION ENVELOPE**
LINEARER MIKROWELLENLEISTUNGSVERSTÄRKER MIT DURCH DIE MODULATIONSUMHÜLLENDE GESTEUERTE STROMVERSORGUNG
AMPLIFICATEUR DE PUISSANCE LINEAIRE HYPERFREQUENCE AVEC INJECTION DE LA PUISSANCE D'ALIMENTATION COMMANDEE PAR UNE ENVELOPPE DE MODULATION

(30) Priority: 07.06.1994 IT MI941179
(43) Date of publication of application: 26.03.1997
(73) Proprietor: Siemens Information and Communication Networks S.p.A., 20126 Milano (IT); Nicelli, Bruna(hiress of the deceased inventor), 27040 Montescano (IT)
(72) Inventor: RICCARDI, Daniele, Deceased (IT); ABBIATI, Antonio, I-20079 San angelo Lodigiano (IT); BUOLI, Carlo, I-41030 Mirandola (IT)
(74) Representative: Giustini, Delio
(86) International application number: EP9502163
(87) International publication number: WO9534128

(56) References cited:
- FR-A- 2 075 020
- FR-A- 2 523 782
- US-A- 4 498 057
- 39TH IEEE VEHICULAR TECHNOLOGY CONFERENCE , vol. 1, 1 - 3 May 1989 SAN FRANCISCO, CALIFORNIA, pages 17-18, XP 000076154 M.J. KOCH ET AL 'A HIGH EFFICIENCY 835 MHZ LINEAR POWER AMPLIFIER FOR DIGITAL CELLULAR TELEPHONY'

## Description

The present invention relates to the field of electronic radiofrequency signal amplifiers and specifically to a linear microwave power amplifier with supply power injection controlled by the modulation envelope.

A valuable feature of power amplifiers regardless of the range of operating frequencies is that of having high energy efficiency i.e. ratio of useful power supplied to the load to power absorbed by the supply source.

The problem of improving the energy efficiency of amplifiers is of such vast importance that it has stimulated the search for ever new solutions regardless of the particular class of operation thereof.

Some known solutions concerning the above mentioned problem take their departure from observations made on the behaviour in time of the amplitudes of the vocal and musical signals which often must be amplified. As a result the above said behaviour shows the random onset of amplitude peaks, which are short-lived compared with the lower and medium amplitudes of greater duration. In correspondence of the amplitude peaks, the amplifiers absorb power peaks from the supplies. The requisites of linearity of the amplifiers require that even during absorption peaks, the supply voltage be kept sufficiently high not to cause saturation of the amplification devices, and thus avoid rising of distortions in the amplified signals. As a consequence the voltage will always be higher than that actually necessary during the greater part of the signal time, and thus causing a useless dispersion by the amplification devices, which could be avoided by lowering the supply voltage outside the peaks. This is the suggestion of a large number of the known solutions which propose the use of two different supply voltages, of which the first only during absorption peaks and the second, lower than the first, for the rest of the time. Operating this way increases the efficiency of an amplifier in comparison with the case of individual supply, because for equal power supplied to a resistive load the supply voltage diminishes on average.

The peaks in the time behaviour of the voice signal amplitudes are present also in radiofrequency carriers amplitude-modulated by the above mentioned base band signals. In the case of radio-modulated carriers, the power amplification problem arises essentially for transmission purposes. In these case however there arise some problems in the use of amplifiers with two different supply voltages, since the frequencies are much higher than those of the base band voice signals. For example, in the power amplifiers used in digital radio links the frequencies fall within microwaves.

A first example of an amplifier using two supply voltages to increase the energy efficiency is described in Japanese patent application JP 60-130905. In the annexed FIG. 3, is shown an amplifier using two pairs of transistors Q1, Q2 and Q3, Q4 connected to a same load R_{L}. A first pair Q1, Q2 is supplied by two voltages +E_{L} and -E_{L} and amplifies the lowest levels of the input signal in accordance with a push-pull diagram. The second pair Q3, Q4 is supplied by two voltages +E_{H} and -E_{H}, with |E_{H}| > |E_{L}|, and amplifies the highest levels of the input signal in equivalent configuration. Selection of one or the other pair is brought about by the input signal level as shown in FIG. 4. As the circuit is perfectly symmetrical, it is possible to restrict the following discussion to the positive levels only, while the dual observations for negative values are obtained by analogy. Therefore when the input level is lower than +E_{L} the first transistor Q5 is active and feeds the transistor Q1 of the first pair. A current switch comprising the transistors Q9, Q10 and Q15 interdicts a second transistor Q6, whose function is to feed the transistor Q3 of the second pair, which therefore remains interdicted. When the input level exceeds +E_{L}, the current switch takes transistors Q6 and Q3 into conduction, and at the same time interdicts Q5 and Q1.

A second example of a double-supply amplifier is set forth in United States patent application US-A-4 498 057, in which is described an amplifier unit which differs from the previous one substantially because provisions are made to discriminate between lower and higher frequencies of the input signal for the precise aims, in occurrence of the higher frequencies, both of saving power and preventing the power supplies be frequently switched-over between them, causing noise generation, and developing distortion. For saving power during the peak of the input signal the higher level power supply replaces the previous one and the driver transistors of the respective finals are controlled in such a way that the polarisation voltage across said finals follow an amplified partition of the input signal added to the output voltage of the lower level power supply.

The greatest shortcoming of the amplifiers of the above examples is identical to that of the amplifier of a third example immediately following in the description and therefore it is discussed below.

A third example of a double-supply amplifier is set forth in United States patent application US-A-4 598 255, in which is described an amplifier unit comprising amplifier means for receiving an input signal and producing an amplified output signal, first means for supplying a first, relatively low, supply voltage to the amplification means, second means for supplying a second, relatively high supply voltage to the amplification mean, and control means for coupling the first means with the amplification means, when the level of the amplified output signal is less than the first supply voltage, and coupling the second means, with the amplification means, when the level of the amplified output signal is greater than the first supply voltage.

The great shortcoming common to the amplifiers of the three examples mentioned is that they are completely unsuited for amplification of amplitude or amplitude and phase modulated radiofrequency carriers. The shortcoming is due to the fact that switching the connection to one or the other supply or, in an entirely equivalent manner, the connection of the load to one or the other amplifier, takes place on instantaneous voltage values of the signal to be amplified or already amplified. With modulated carriers this would mean, e.g. having to switch currents even of a few amperes with a frequency of a few tens of MHz in the best cases and several GHz in the worst cases. This would appear to be entirely impracticable because of the manufacturing difficulties and the prohibitive cost of suitable devices. Furthermore, if it were desired to actually implement an amplifier, switching between two supply voltages on the instantaneous amplitude values of the signal, it would be necessary first to eliminate the trap filters usually used in radiofrequency amplifiers on the-supply connections, to avoid propagation of the signal towards the supplies. In this manner powerful electromagnetic disturbances, such as to make operation of the amplifier critical, would be propagated in the circuit.

Accordingly the purpose of the present invention is to overcome the above mentioned shortcomings and indicate a linear power amplifier for radiofrequency signals, and specifically microwave signals, with injection of supply power controlled by the modulation envelope of the radiofrequency signal, in order to increase its energy efficiency.

To achieve these purposes, the subject matter of the present invention which is defined in claim 1 is a linear radiofrequency signal amplifier comprising a first transistor acting as power amplifier, supplied by a first supply with voltage +V_{A}, through a diode and an inductor in series, and by a second supply with voltage +V_{B} > +V_{A} through a second transistor, through which flows the current of the second supply. A radiofrequency signal to be amplified RF'in is taken from a directional coupler and brought respectively to the input of the first transistor, by means of a delay line, and to an envelope detector followed by an envelope amplifier, which superimposes on the amplified envelope a continuous voltage +Vreg < +V_{A}, to obtain an output signal Vp. The second transistor brings the voltage Vp back to its own emitter. As long as Vp ≤ V_{A}, the diode conducts while interdicting the second transistor, and in this case the supply current of the amplifier comes only from the first supply.

During the peaks of RF'in, Vp > +V_{A} and the second transistor conducts; in this case the inductor prevents the current peak coming from the second supply, from traversing the parasite capacitance of the diode and reaching the first supply. The delay line on the path of RF'in towards the first transistor has a length such as to put the amplitude peaks of the input signal of the first transistor in phase with the corresponding current peaks supplied by the second supply, as better described in the claims. Second transistor, diode and inductor perform a power supply switch.

As may be seen, in the amplifier which is the subject matter of the present, invention switching towards the higher supply voltage takes place on the peaks of the modulation envelope, rather than on the instantaneous amplitude values of the radiofrequency signal. The modulation envelope is correlated with the mean power of the radiofrequency signal, and hence varies much more slowly than the instantaneous amplitude values. It is thus still possible to use radiofrequency trap filters on the connections to the supplies and anything else necessary for eliminating the negative effects of the radiofrequency disturbances. It is also simpler to find the devices suitable for switching towards one or the other of the supply voltages.

In conclusion, even for amplitude modulated radiofrequency carriers, a double supply amplifier can be provided.

The amplifier which is the subject matter of the present invention shows high energy efficiency, and at the same time excellent linearity in a broad range of frequencies. The advantage of this is that it allows considerable power economy, which means use of supply and heat-sinks less cumbersome and costly and hence perfectly meeting present requirements of miniaturisation of radio apparatuses, and specifically those used in digital microwave radio links. Another advantage is that of prolonging the operational life of the power amplifying devices, because the temperature in the devices is reduced, due to the effect of less power which they have to sink.

A radiofrequency amplifier which makes use of an envelope detector for controlling the voltage supplied to the power transistor is disclosed in the 39^{TH} IEEE VEHICULAR TECHNOLOGY CONFERENCE, vol. 1,1-3 May 1989, SAN FRANCISCO, CALIFORNIA, pages 17-18, XP 000076154, M.J. KOCH ET AL, "HIGH EFFICIENCY 835 MHz LINEAR POWER AMPLIFIER FOR DIGITAL CELLULAR TELEPHONY". The amplifier therein disclosed includes a particular arrangement for linearising a class C radiofrequency power transistor for a 835 MHz QAM transmitting signal. As known a class C amplifier works in a saturation mode which clip the level of the output signal. Such an amplifier is useful for FM signals but not for amplitude modulated signals, for example QAM. The teaching of the article is that of modulating the DC collector voltage of the power transistor for introducing the amplitude information into the output signal, otherwise lost. For this purpose an envelope detector inserted in a forward branch generates the base band envelope of the RF signal for controlling a PWM amplifier. A pass bass filter following PWM provides the modulated DC collector voltage. A pass bass filter following PWM provides the modulated DC collector voltage. The signal at the output of the RF amplifier reaches a second envelope detector used for correcting in a feedback mode the output of the former envelope detector and obtaining a third order intermodulation products 30 dB down.

The approach for saving power adopted in the radiofrequency amplifier of the latter citation is that of using a class C amplifier. Consequently in presence of a QAM signal the problem to be solved is that of how linearising the amplifier. The above approach is completely different from ours in which the amplifier is already linear and the power is saved by switching between a high level voltage and a low level voltage power supply on the basis of the peaks of the detected envelope. In so, the envelope detector is used in the two cases for aims also completely different each other, and from the latter citation it can't be obtained any teaching useful for our invention. The combination between the former prior art and the latter citation appears not to be realistically proposable, mainly because of the different nature of the two amplifiers where an envelope detection, fundamental in a radiofrequency amplifier, is useless in an audio amplifier.

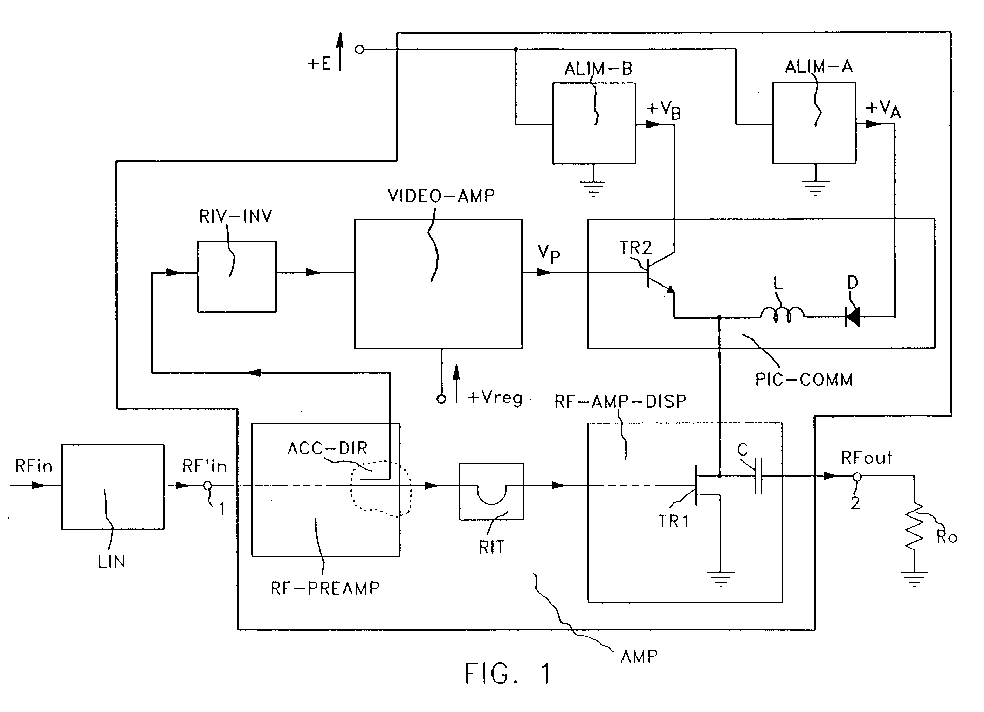

The characteristics and advantages of the present invention are clarified in the detailed description of an embodiment thereof given below by way of non-limiting example with reference to the annexed drawing, in which:
the only FIG. 1 shows a block diagram, and partly circuit diagram, of the amplifier which is the subject matter of the present invention.

With reference to FIG. 1 there is seen a block AMP representing the amplifier which is the subject matter of the present invention, consisting of the blocks RF-PREAMP, RIT, RF-AMP-DISP, RIV-INV, VIDEO-AMP, PIC-COM, ALIM-A and ALIM-B.

The amplifier AMP has an input port 1 at which arrives a microwave signal RF'in, which is power amplified and coupled with an output port 2 as signal RFout, made available to a load Ro connected between the terminal 2 and ground. The signal RF'in comes from a block LIN which represents a predistortion lineariser of known type, at whose input is present a signal RFin. The latter is a 64-QAM modulated microwave carrier, but it could also be any amplitude modulated radiofrequency signal in accordance with other amplitude modulation diagrams, provided that in the amplitude behaviour of the modulated signal there occur peaks of short duration. More generally it is required that the modulating signal have a high dynamic, i.e. exhibit a high peak-to-average amplitude ratio.

The block RF-PREAMP is a microwave-operating preamplifier of known type, which amplifies the signal RF'in at low power levels. The preamplified signal is taken from a directional coupler ACC-DIR also of known type and respectively coupled to a delay line RIT and to an envelope detector RIV-INV, both of known type.

The preamplified signal after traversing the delay line RIT, reaches the input of the block RF-AMP-DISP which represents a microwave-operating power amplifier also of known type, and based on the use of a field effect transistor TR1 having its source connected to ground. The signal amplified by RF-AMP-DISP is coupled by means of a capacitor C to the output port 2 of AMP and thence to the load Ro.

The modulation envelope present at the output of RIV-INV reaches an input of a video amplifier VIDEO-AMP, to a second input of which is applied a d.c. voltage +Vreg. At the output of VIDEO-AMP is present a signal Vp which reaches the base of a bipolar transistor TR2 included in the block PIC-COMM.

The block PIC-COMM represents a supply switch controlled by the amplitude peaks of the signal Vp, and comprises in addition to TR2 a diode D with an inductor L in series. Specifically the anode of the diode D is connected to the output of a first supply ALIM-A which supplies a continuous voltage +V_{A}, while the cathode is connected to one end of the inductor L, whose other end is connected to the drain of TR1. The collector of TR2 is connected to the output of a second supply ALIM-B which supplies a continuous voltage +V_{B} having a higher value than the voltage +V_{A}. The emitter of TR2 is also connected to the drain of TR1. Both the ALIM-A and ALIM-B are in turn connected to a common source not shown in the figure, and which supplies a d.c. voltage +E for operation of both. Although not shown expressly in FIG. 1, the blocks VIDEO-AMP and RF-PREAMP are supplied by ALIM-B while the blocks RIV-INV and RIT require no supply.

In operation it is useful to make some preliminary remarks concerning the type of modulation of the signal RFin, if it is the QAM type or equivalent. The purpose is to further clarify the basic assumption which led both in the prior art and the present invention to the idea of using two switchable supply voltages for one amplifier. It is assumed that in the signal to be amplified there are random amplitude peaks of shorter duration than lower amplitudes lasting longer on average. This characteristic of the signal is immediately comprehensible for base-band voice and music signals or radio carriers modulated thereby, while it is not so much so for the QAM modulated carriers, where the modulating signals are in general data. Thus QAM modulation is a characteristic of digital signals and acts simultaneously on the amplitude and the phase of a radio carrier. A graphic representation of this type of modulation is obtained by putting in one plane the end point of a vector which assumes all the possible values of a modulated carrier. All together the points constitute a constellation from which can be calculated the ratio of peak power to mean power of the modulated signal, and the band width deriving therefrom. For example for a 64-QAM modulation this ratio is approximately 6dB and the frequency band extends from zero to approximately 40MHz.

One consequence which can be drawn from the foregoing is that the amplifiers which process QAM signals, especially if with many modulation levels, must be very linear to not distort the constellation and thus cause demodulation errors. In these cases the lineariser LIN becomes indispensable. For this purpose it is possible to use in a non-limiting manner the lineariser described in European patent application No. 91200799.4, filed in the name of this same applicant. The signal RF'in at the output of the lineariser exhibits slight amplitude and phase predistortions of equal value and opposite sign from the distortions otherwise introduced by TR1. As regards the distortions introduced by the GaAsFET TR1, some values are given below.

Continuing the remarks on operation, as may be seen even from FIG. 1, the preamplified signal RF'in follows two different tracks, the first of which leads it directly to the gate of the GaAsFET TR1, after traversing the delay line RIT, and a second leads it to the envelope, detector RIV-INV which extracts therefrom the modulation envelope, which is then duly amplified by VIDEO-AMP and superimposed on the voltage +Vreg in a known manner, to obtain the signal Vp. The signal Vp is taken back by TR2 between the drain and source of TR1, and when TR2 conducts, constitutes the bias voltage V_{DS} of TR1. In conclusion, a generic amplitude peak of RF'in reaches TR1 along two different tracks, of which the first passed through the peak included in the radiofrequency signal, and the second by that included in the modulation envelope.

The delay line RIT serves to compensate, on the first track to TR1, for the greater delay present along the second track, so that the amplitude peaks of RF'in at the input of the GaAsFET TR1 are in phase with the corresponding amplitude peaks of the envelope of RF'in contained in the voltage Vp, repeated by TR2. The different delays on the two tracks are essentially due to the different lengths of the paths, but as concerns the second track the delay introduced by the blocks ACC-DIR, RIV-INV, VIDEO-AMP and the TR2 also counts.

The block VIDEO-AMP represents any amplifier of known type capable of amplifying linearly both the d.c. signals and the alternate signals, with frequency in the significant frequency band of the modulation envelope. In practice, the band of the envelope signals cannot extend beyond 60MHz, although it is beneficial to use for VIDEO-AMP a linear amplifier, whose transfer function has a constant amplitude and a phase varying linearly in a rather extended band, e.g. from 0 to 200MHz, and thus characterized by smaller input/output delays which can be compensated for by means of shorter delay lines RIT.

At this point it is specified that in FIG. 1 a prelimnary diagram is shown sufficient to describe in an adequate manner the amplifier which is the subject matter of the present invention. Those skilled in the art are in any case capable of introducing all that is known and usually serves for the good operation of such a circuit, such as for example: trap filters on the supply lines, coupling filters for the modulation envelope signal, the input and output filters of the microwave signal, the bias networks for the transistors TR1 and TR2, etc. In particular the transistor TR2 can even be a FET, and in this case it is necessary to change the voltage +Vreg to have the voltage Vp supply the bias voltage V_{GS} of the FET TR2.

For the transistor TR1 there was used the Fujitsu GaAsFET FLM3742-25DA capable of supplying a power of 25W over the entire frequency range between 3.7GHz and 4.2GHz, when polarised by a nominal voltage V_{DS} = 10V and a nominal current I_{DS} = 6.2A. The nominal values which determine the opereating point are in general supplied by the manufacturers of the devices, to have maximum radiofrequency output and ensure sufficient reliability for the device.

The main consideration on which is based the present invention originated with the experimental observation that the parameters s of the diffusion matrix of the GaAsFET TR1 show slight dependence on the voltage V_{DS} and the current I_{DS} of the operating point within a certain range of values below the nominal values. Consequently, for the low values of the input signal RF'in it is possible to bias the GaAsFET with a voltage V_{DS} approximately half of nominal value and an I_{DS} approximately 40% lower, introducing only slight distortion on the amplified signal, but saving considerable supply power. In the case of the example, when the GaAsFET TR1 is biased with V_{DS} = 5V and I_{DS} = 4A, instead of the nominal values of 10V and 6.2A, from the measurements made, the gain varies by only 0.2dB and the phase by approximately 2°.

The above remarks apply equally for other types of device, e.g. the normal FETs operating at frequencies lower than microwaves or bipolar transistors, and this allows extending operation of the amplifier which is the subject matter of the present invention in different frequency ranges.

From the above remarks on the operating point of TR1 and on the operation of AMP, the voltage +VA can be set at 7.5V and +VB at 14V. The mean current IDS = 4A, taken from ALIM-A, is determined by the bias network of TR1. Mean current absorbed from the ALIM-B, was approximately 0.5A with a 64-QAM signal, with a value of 50µH for the inductor L.

From the values supplied it is possible to calculate the power savings over the conventional case using a single supply giving the nominal bias values of TR1 indicated by the manufacturer. In the example the total power absorbed by the supplies is (7.5x4) + (14x0.5) = 37.5W, while in the conventional case absorbed power would not be less than 10x6.2 = 62W. The power saving is 62-37.5 = 24.5W which as a percentage would be (24.5/62)x100 = 39.5%.

It is useful to analyse the operation of the amplifier AMP, first for slowly changing input signals and then for rapidly changing signals. It is noted that for slowly changing signals it is intended to refer to amplitude modulated carriers (QAM), in which the envelope changes slowly, so as the inductor L can be considered a short circuit and the diode D ideal. It must also be assumed that the supply ALIM-B is capable of supplying the nominal current 6.2A for the GaAsFET TR1. Under this assumption it is seen that TR2 begins conduction when the voltage Vp exceeds +V_{A}. In this case, with TR2 acting as emitter-follower, the voltage Vp is brought back to the drain of TR1 where it constitutes a bias voltage V_{DS} of TR1, varying in dependence on the modulation envelope of the signal RF'in. The conduction of TR2 coincides with the interdiction of the diode D and with the exclusion of the supply ALIM-A, and in this case the peak current comes entirely from ALIM-B. Since Vp is the sum of the voltage +Vreg and the envelope voltage of the signal RF'in amplified by VIDEO-AMP, the conduction of TR2 places an upper limit on the voltage +Vreg. Indeed, supposing the signal RF'in to be absent, is Vp = +Reg, and in this case the highest value of +Reg must not cause conduction of TR2, so that the current I_{DS} of the GaAsFET TR1 comes entirely from the supply ALIM-A. In practice, only concerning the preceding statement, +Vreg should never exceed the value of approximately +V_{A}. However, this value is not applicable since, in the presence of the signal RF'in, TR2 would go into conduction for excessively low levels of the envelope signal, and there would then be no discrimination between low and peak amplitude levels, of the signal RF'in, to control injection of the further power by the supply ALIM-B. It is necessary to set a lower limit for +Vreg, so that the amplitude of Vp causing the transistor TR2 to begin conducting would correspond to a predetermined threshold for the above mentioned discrimination. Consequently control means are provided for the voltage +Vreg not shown in the figure.

Again from the original position, i.e. with slowly changing envelope signals, the gain of VIDEO-AMP must be such that the voltage Vp transferred onto the emitter of TR2, on the envelope amplitude peaks, does not exceed 10V of the nominal V_{DS} of TR1 set by the manufacturer.

Analyzing the behaviour of the amplifier AMP for rapidly changing input signals, in this case the inductor L can no longer be considered as a short circuit, and the diode D is no longer considered ideal.

With signals RF'in 64-QAM modulated, the above mentioned threshold discriminating between low and peak amplitude values is passed through very rapidly in both directions, because the duration of the peaks can also be very short, e.g. on the order of 20 nanoseconds. This circumstance causes no particular operating problems for the transistor TR2. Today inexpensive transistors which amplify without distorting signals having band width of 200MHz and more, and are hence capable of responding to such short amplitude peaks, are readily available. A possible limitation could come from the diode D which, without using the inductor L, could be difficult to find and very costly. Such a diode should be capable of switching 4A currents in less time than the minimum duration of the peaks. The inductor L has a value of 50µH which is high enough to stop passage towards ALIM-A of the fast current peaks supplied by TR2, which otherwise would traverse the parasite capacitance in parallel with the junction of the diode D, and would reach ALIM-A because of the lower voltage. The diode D thus can reach the interdiction state more slowly and is no longer a critical and costly component. The function of the inductor L is more complex than that of a simple block inductor and in reality it also acts as a "flywheel" as concerns the fast supply current peaks, since it is charged by absorbing energy from ALIM-A and supplies prevalently the peak current as long as TR2 has not reached clear conduction, thus avoiding an instantaneous switching between the two supplies which in any case would be difficult to implement.

## Claims

1. Amplifier of amplitude-modulated or amplitude and phase modulated radiofrequency signals having amplitude peaks of shorter duration than lower amplitude values of longer mean duration, comprising:
- means for reception of said radiofrequency signal and for coupling to radiofrequency amplification means;
- first power supply means supplying a relatively low supply voltage to said amplification means;
- second power supply means supplying a relatively high supply voltage to said amplification means;
- means of connection and control connecting said first or second power supply means to said amplification means and **characterized in that**:
said reception and coupling means (ACC-DIR, RIT) are arranged for coupling the radiofrequency signal (RF'in) to said amplification means (RF-AMP-DISP) on a first branch and to said connection and control means (RIV-INV, VIDEO-AMP, PIC-COMM) on a second branch, and in that
said connection and control means comprising an envelope detector (RIV-INV) to detect the modulation envelope of said radiofrequency signal (RF'in), and further comprising a power supply switch (PIC-COMM) to discriminate between low and peak amplitudes of the detected modulation envelope and to connect the first power supply means (ALIM-A) to the amplification means (RF-AMP-DISP) in the presence of said low amplitude values of said envelope, while in the presence of the amplitude peaks of the envelope to disconnect the first power supply means (ALIM-A) from the amplification means (RF-AMP-DISP) and simultaneously connect the second power supply means (ALIM-B) to the amplification means (RF-AMP-DISP).

2. Amplifier of amplitude-modulated or amplitude and phase modulated radiofrequency signals in accordance with claim 1, characterized in that said reception and coupling means (ACC-DIR,RIT) comprise a directional coupler (ACC-DIR) which couples the radiofrequency signal (RF'in) to the first and second branches and a delay line (RIT) inserted along the path of the first branch for putting in phase the amplitude peaks of the radiofrequency signal at the input of the amplification means (RF-AMP-DISP) with corresponding current peaks coming from said second power supply means (ALIM-B).

3. Amplifier of amplitude-modulated or amplitude and phase modulated radiofrequency signals in accordance with claim 1, characterized in that said power supply switch (PIC-COMM) which discriminates between low and peak amplitude values of said modulation envelope comprises:
- diode means (L,D) which in the presence of said low amplitudes of the envelope connect said first power supply means (ALIM-A) to said amplification means (RF-AMP-DISP), and
- a transistor (TR2) which in the presence of said amplitude peaks of the envelope connects said second power supply means (ALIM-B) to said amplification means (RF-AMP-DISP) and simultaneously interdicts said diode means (L,D), causing disconnection of said first power supply means (ALIM-A) from said amplification means.

4. Amplifier of amplitude-modulated or amplitude and phase modulated radiofrequency signals in accordance with claim 3, characterized in that said transistor (TR2) is connected between said second power supply means (ALIM-B) and said amplification means (RF-AMP-DISP) in voltage follower configuration, the voltage controlling said transistor (TR2) being supplied by a video amplifier (VIDEO-AMP) which follows said envelope detector (RIV-INV) for amplifying the envelope's voltage and superimposing a d.c. voltage (+Vreg) lower than the voltage (+V_{A}) supplied by said first power supply means (ALIM-A); said d.c. voltage (+Vreg) controlling the start of conduction of said transistor (TR2) and discriminating between said low and peak amplitudes of said modulation envelope.

5. Amplifier of amplitude-modulated or amplitude and phase modulated radiofrequency signals in accordance with claim 3, characterized in that said diode means (L,D) consist of a diode (D) in series with an inductor (L) having a value such as to prevent the short-duration current peaks coming from said second power supply means (ALIM-B), and corresponding to said amplitude peaks of the envelope from traversing the parasite capacitance of said diode (D) and reaching said first power supply means (ALIM-A).

6. Radiofrequency signal amplifier in accordance with claim 3, characterized in that said amplification means (RF-AMP-DISP) include a preferably field effect radiofrequency power transistor (TR1) whose drain is connected to the emitter or to the source of said transistor (TR2) belonging to said power supply switch (PIC-COMM), and to one end of said diode means (L,D) not connected to said first power supply means (ALIM-A).

7. Radiofrequency signal amplifier in accordance with claim 6, characterized in that said power transistor (TR1) is biased with voltage values V_{DS} and current values I_{DS} lower than nominal values such that it is possible to obtain a maximum radiofrequency power output without introducing significant distortions in the amplified signal (RFout).

8. Radiofrequency signal amplifier in accordance with any of the above claims, characterized in that said radiofrequency signals (RF'in) are QAM modulated in accordance with a diagram having numerous modulation levels.

9. Amplifier of amplitude-modulated or amplitude and phase modulated radiofrequency signals in accordance with claim 8 and characterized in that said amplifier (AMP) is preceded by a lineariser (LIN) to whose input arrive said radiofrequency signal (RFin).

## Patentansprüche

1. Es handelt sich um einen Verstärker für amplituden- oder amplituden- und phasenmodulierte Hochfrequenzsignale, deren Amplitudenspitzenwerte von kürzerer mittlerer Dauer sind als die niedrigeren Amplitudenwerte. Der Verstärker umfasst folgende Komponenten:
- Eine Komponente zum Empfang des vorgenannten Hochfrequenzsignals und zur Ankopplung an die Hochfrequenzverstärkerkomponenten.
- Eine erste Stromversorgungskomponente, die die vorgenannte Verstärkerkomponente mit einer relativ niedrigen Versorgungsspannung versorgt.
- Eine zweite Stromversorgungskomponente, die die vorgenannte Verstärkerkomponente mit einer relativ hohen Versorgungsspannung versorgt.
- Eine Komponente zur Anbindung und Steuerung der ersten bzw. zweiten Stromversorgungskomponente an die vorgenannte Verstärkerkomponenten **mit folgenden Merkmalen:**
Die vorgenannten Empfangs- und Ankopplungskomponenten (ACC-DIR, RIT) koppeln das Hochfrequenzsignal (RF'in) über einen ersten Pfad an die vorgenannte Verstärkerkomponente (RF-AMP-DISP) und über einen zweiten Pfad an die vorgenannten Anschluss- und Steuerkomponenten (RIV-INV, VIDEO-AMP, PIC-COMM).
Die vorgenannten Anschluss- und Steuerkomponenten beinhalten einen Hüllkurvendetektor (RIV-INV) zum Erkennen der Modulationshüllkurve des vorgenannten Hochfrequenzsignals (RF'in), weiterhin einen Stromversorgungsumschalter (PIC-COMM) zur Unterscheidung von niedrigen und hohen Amplitudenwerten der erkannten Modulationshüllkurve und zum Anschalten der ersten Stromversorgungskomponente (ALIM-A) an die Verstärkerkomponente (RF-AMP-DISP) bei geringen Amplitudenwerten der Modulationshüllkurve. Bei Amplitudenspitzenwerten der Hüllkurve wird damit die erste Stromversorgungskomponente (ALIM-A) von der Verstärkerkomponente (RF-AMP-DISP) getrennt und gleichzeitig die zweite Stromversorgungskomponente (ALIM-B) an die Verstärkerkomponente (RF-AMP-DISP) angeschaltet.

2. Es handelt sich um einen Verstärker für amplituden- oder amplituden- und phasenmodulierte Hochfrequenzsignale entsprechend Patentanspruch 1 mit der vorgenannten Empfangs- und Ankopplungskomponente (ACC-DIR, RIT). Diese enthält einen Richtungskoppler (ACC-DIR), der das Hochfrequenzsignal (RF'in) an den ersten und zweiten Pfad ankoppelt, und eine Verzögerungsleitung (RIT) im ersten Pfad, die die Amplitudenspitzenwerte des Hochfrequenzsignals am Eingang der Verstärkerkomponente (RF-AMP-DISP) mit den entsprechenden Stromspitzenwerten von der vorgenannten zweiten Stromversorgungskomponente (ALIM-B) in Phase bringt.

3. Es handelt sich um einen Verstärker für amplituden- oder amplituden- und phasenmodulierte Hochfrequenzsignale entsprechend Patentanspruch 1 mit einem Stromversorgungsumschalter (PIC-COMM), der zwischen niedrigen und hohen Amplitudenwerten der Modulationshüllkurve unterscheidet und folgende Komponenten enthält:
- Eine Diodenkomponente (L, D), die bei niedrigen Hüllkurvenamplituden die erste Stromversorgungskomponente (ALIM-A) mit der Verstärkerkomponente (RF-AMP-DISP) verbindet und
- Einen Transistor (TR2), der bei Amplitudenspitzenwerten der Hüllkurve die zweite Stromversorgungskomponente (ALIM-B) mit der Verstärkerkomponente (RF-AMP-DISP) verbindet und gleichzeitig über die vorgenannte Diodenkomponente (L, D) die erste Stromversorgungskomponente (ALIM-A) von der Verstärkerkomponente trennt.

4. Es handelt sich um einen Verstärker für amplituden- oder amplituden- und phasenmodulierte Hochfrequenzsignale entsprechend Patentanspruch 3, bei dem der vorgenannte Transistor (TR2) zwischen die zweite Stromversorgungskomponente (ALIM-B) und die Verstärkerkomponente (RF-AMP-DISP) geschaltet ist (Spannungsfolgerkonfiguration). Der die Spannung steuernde Transistor (TR2) wird vom Videoverstärker (VIDEO-AMP) angesteuert, der dem Hüllkurvendetektor (RIV-INV) nachgeschaltet ist und die Hüllkurvenspannung verstärkt. Es wird eine Gleichspannung (+Vreg) überlagert, die niedriger als die von der ersten Stromversorgungskomponente (ALIM-A) gelieferte Spannung (+V_{A}) ist. Die Gleichspannung (+Vreg) steuert den Beginn des Durchschaltens des Transistors (TR2) und sorgt für die Unterscheidung zwischen niedrigen und hohen Amplitudenwerten der Modulationshüllkurve.

5. Es handelt sich um einen Verstärker für amplituden- oder amplituden- und phasenmodulierte Hochfrequenzsignale entsprechend Patentanspruch 3, dessen vorgenannte Diodenkomponente (L, D) aus einer mit einer Drosselspule (L) in Reihe geschalteten Diode (D) besteht. Diese Bauteile sind so bemessen, dass die von der zweiten Stromversorgungskomponente (ALIM-B) stammenden kurzzeitigen Stromspitzenwerte, die den Amplitudenspitzenwerten der Hüllkurve entsprechen, nicht über die parasitäre Kapazität der Diode (D) an die erste Stromversorgungskomponente (ALIM-A) gelangen können.

6. Es handelt sich um einen Hochfrequenzsignalverstärker entsprechend Patentanspruch 3, dessen vorgenannte Verstärkerkomponente (RF-AMP-DISP) (vorzugsweise) einen Feldeffekt-Hochfrequenzleistungstransistor (TR1) enthält, dessen Drain mit dem Emitter bzw. der Source des vorgenannte Transistors (TR2) des Stromversorgungsumschalters (PIC-COMM) und dem der ersten Stromversorgungskomponente (ALIM-A) abgewandten Anschluss der vorgenannten Diodenkomponente (L, D) verbunden ist.

7. Es handelt sich um einen Hochfrequenzverstärker entsprechend Patentanspruch 6, bei dem der vorgenannte Leistungstransistor (TR1) mit geringeren als den Nennwerten für Spannung V_{DS} und Strom I_{DS} vorgespannt wird, um eine maximale Hochfrequenzleistung ohne wesentliche Störungen des verstärkten Signals (RFout) zu erreichen.

8. Es handelt sich um einen Hochfrequenzsignalverstärker entsprechend den vorgenannten Patentansprüchen, der für QAM-modulierte Hochfrequenzsignale (RF'in) geeignet ist, deren Modulationsdiagramm eine große Anzahl von Modulationsstufen enthält.

9. Es handelt sich um einen Verstärker für amplituden- oder amplituden- und phasenmodulierte Hochfrequenzsignale entsprechend Patentanspruch 8, bei dem dem vorgenannten Verstärker (AMP) ein Linearisierer (LIN) vorgeschaltet ist, an dessen Eingang das Hochfrequenzsignal (RFin) anliegt.

## Revendications

1. Amplificateur de signaux haute fréquence modulés en amplitude ou modulés en amplitude et en phase ayant des pics d'amplitude de durée plus courte que les valeurs d'amplitude inférieures de durée moyenne plus longue, comprenant :
- des moyens de réception dudit signal haute fréquence et de couplage de moyens d'amplification haute fréquence ;
- un premier moyen d'alimentation fournissant une tension d'alimentation relativement basse auxdits moyens d'amplification ;
- un second moyen d'alimentation fournissant une tension d'alimentation relativement élevée auxdits moyens d'amplification ;
- des moyens de connexion et de commande connectant lesdits premier ou second moyens d'alimentation auxdits moyens d'amplification et **caractérisé en ce que :**
lesdits moyens de réception et de couplage (ACC-DIR, RIT) sont agencés pour coupler le signal haute fréquence (RF'in) auxdits moyens d'amplification (RF-AMP-DISP) sur un premier branchement et auxdits moyens de connexion et de commande (RIV-INV, VIDEO-AMP, PIC-COMM) sur un second branchement, et en ce que :
lesdits moyens de connexion et de commande comprennent un détecteur d'enveloppe (RIV-INV) pour détecter l'enveloppe de modulation dudit signal haute fréquence (RF'in) et comprennent par ailleurs un commutateur d'alimentation (PIC-COMM) pour discriminer les amplitudes faibles et maximales de l'enveloppe de modulation détectée et pour connecter le premier moyen d'alimentation (ALIM-A) aux moyens d'amplification (RF-AMP-DISP) en présence desdites valeurs d'amplitude faibles de ladite enveloppe, alors qu'en présence des amplitudes maximales de l'enveloppe, il déconnecte le premier moyen d'alimentation (ALIM-A) des moyens d'amplification (RF-AMP-DISP) et connecte simultanément le second moyen d'alimentation (ALIM-B) aux moyens d'amplification (RF-AMP-DISP).

2. Amplificateur de signaux haute fréquence modulés en amplitude ou modulés en amplitude et en phase selon la revendication 1, caractérisé en ce que lesdits moyens de réception et de couplage (ACC-DIR, RIT) comprennent un coupleur directif (ACC-DIR) qui couple le signal haute fréquence (RF'in) aux premier et second branchements et une ligne à retard (RIT) insérée sur le trajet du premier branchement pour mettre en phase les pics d'amplitude du signal haute fréquence à l'entrée des moyens d'amplification (RF-AMP-DISP) avec les courants de crête correspondants provenant dudit second moyen d'alimentation (ALIM-B).

3. Amplificateur de signaux haute fréquence modulés en amplitude ou modulés en amplitude et en phase selon la revendication 1, caractérisé en ce que ledit commutateur d'alimentation (PIC-COMM) qui discrimine les valeurs d'amplitude faibles et maximales de ladite enveloppe de modulation, comprend :
- des moyens formant diode (L, D) qui, en présence desdites amplitudes fiables de l'enveloppe, connectent ledit premier moyen d'alimentation (ALIM-A) auxdits moyens d'amplification (RF-AMP-DISP), et
- un transistor (TR2) qui, en présence desdites amplitudes maximales de l'enveloppe, connecte ledit second moyen d'alimentation (ALIM-B) auxdits moyens d'amplification (RF-AMP-DISP) et bloque simultanément lesdits moyens formant diode (L, D), causant la déconnexion dudit premier moyen d'alimentation (ALIM-A) desdits moyens d'amplification.

4. Amplificateur de signaux haute fréquence modulés en amplitude ou modulés en amplitude et en phase selon la revendication 3, caractérisé en ce que ledit transistor (TR2) est connecté entre ledit second moyen d'alimentation (ALIM-B) et lesdits moyens d'amplification (RF-AMP-DISP) dans une configuration d'étage suiveur de tension, la tension commandant l'alimentation dudit transistor (TR2) par un amplificateur vidéo (VIDEO-AMP) qui suit ledit détecteur d'enveloppe (RIV-INV) pour amplifier la tension de l'enveloppe et superposer une tension continue (+Vreg) inférieure à la tension (+V_{A}) fournie par ledit premier moyen d'alimentation (ALIM-A), ladite tension continue (+Vreg) commandant le début de l'état conducteur dudit transistor (TR2) et discriminant lesdites amplitudes faibles et maximales de ladite enveloppe de modulation.

5. Amplificateur de signaux haute fréquence modulés en amplitude ou modulés en amplitude et en phase selon la revendication 3, caractérisé en ce que lesdits moyens formant diode (L, D) consistent en une diode (D) montée en série avec une bobine d'inductance (L) ayant une valeur propre à empêcher les courants de crête de courte durée provenant dudit second moyen d'alimentation (ALIM-B) et correspondant auxdits pics d'amplitude de l'enveloppe de traverser la capacité parasite de ladite diode (D) et d'atteindre ledit premier moyen d'alimentation (ALIM-A).

6. Amplificateur de signaux haute fréquence selon la revendication 3, caractérisé en ce que lesdits moyens d'amplification (RF-AMP-DISP) comprennent un transistor de puissance haute fréquence (TR1), de préférence à effet de champ, dont le drain est connecté à l'émetteur ou à la source dudit transistor (TR2) faisant partie dudit commutateur d'alimentation (PIC-COMM), et à l'une des extrémités desdits moyens formant diode (L, D) non connectée audit premier moyen d'alimentation (ALIM-A).

7. Amplificateur de signaux haute fréquence selon la revendication 6, caractérisé en ce que ledit transistor de puissance (TR1) est polarisé avec des valeurs de tension V_{DS} et des valeurs de courant I_{DS} inférieures aux valeurs nominales de telle sorte qu'il est possible d'obtenir une puissance de sortie haute fréquence maximale sans introduire de distorsions notables dans le signal amplifié (RFout).

8. Amplificateur de signaux haute fréquence selon l'une quelconque des revendications précédentes, caractérisé en ce que lesdits signaux haute fréquence (RF'in) sont soumis à une modulation QAM conformément à un diagramme ayant de nombreux niveaux de modulation.

9. Amplificateur de signaux haute fréquence modulés en amplitude ou modulés en amplitude et en phase selon la revendication 8 et caractérisé en ce que ledit amplificateur (AMP) est précédé par un linéariseur (LIN) à l'entrée duquel arrive ledit signal haute fréquence (RFin).
